(19) **Europäisches Patentamt / European Patent Office / Office européen des brevets**

(11) **EP 2 035 597 B1**

(12) **FASCICULE DE BREVET EUROPEEN**

(45) Date de publication et mention
de la délivrance du brevet:
**07.03.2012 Bulletin 2012/10**

(21) Numéro de dépôt: **07765396.2**

(22) Date de dépôt: **13.06.2007**

(51) Int Cl.:
*C23C 16/44* (2006.01)    *B08B 7/00* (2006.01)

(86) Numéro de dépôt international:
**PCT/EP2007/055830**

(87) Numéro de publication internationale:
**WO 2007/144378 (21.12.2007 Gazette 2007/51)**

(54) **DISPOSITIF ET PROCEDE DE NETTOYAGE D'UN REACTEUR PAR PLASMA**

REINIGUNGSVORRICHTUNG UND REINIGUNGSVERFAHREN FÜR EINEN PLASMAREAKTOR

CLEANING DEVICE AND CLEANING PROCESS FOR A PLASMA REACTOR

(84) Etats contractants désignés:
**AT BE BG CH CY CZ DE DK EE ES FI FR GB GR
HU IE IS IT LI LT LU LV MC MT NL PL PT RO SE
SI SK TR**

(30) Priorité: **13.06.2006 FR 0605238**

(43) Date de publication de la demande:
**18.03.2009 Bulletin 2009/12**

(73) Titulaires:
• **CENTRE NATIONAL DE
LA RECHERCHE SCIENTIFIQUE (CNRS)
75016 Paris (FR)**
• **UNIVERSITE JOSEPH FOURIER - Grenoble 1
38400 St. Martin d'Hères (FR)**

(72) Inventeurs:
• **PELLETIER, Jacques Henri
38400 Saint Martin d'Heres (FR)**

• **LACOSTE, Ana
38950 Saint Martin Le Vinoux (FR)**
• **BES, Alexandre
38470 Vinay (FR)**
• **BECHU, Stéphane Jean Louis
38470 Chantesse (FR)**
• **SIROU, Jérôme
38100 Grenoble (FR)**

(74) Mandataire: **Texier, Christian et al
Cabinet Regimbeau
20, rue de Chazelles
75847 Paris Cedex 17 (FR)**

(56) Documents cités:
**JP-A- 3 150 379    JP-A- 63 119 225**

**Description**

Domaine de l'invention

L'invention concerne un dispositif de nettoyage d'un réacteur.

L'invention concerne plus précisément un dispositif de nettoyage par voie chimique sèche assisté par plasma d'un réacteur comportant un dépôt indésirable.

L'invention concerne le procédé de nettoyage d'un réacteur mis en oeuvre avec le dispositif selon l'invention.

De manière générale, l'invention s'applique aux réacteurs utilisant des procédés par voie sèche et dont les parois se recouvrent de dépôts indésirables.

L'invention s'applique au nettoyage de réacteurs de dépôt et traitements de surface.

C'est le cas, par exemple, des réacteurs de dépôt par PACVD (dépôt chimique en phase vapeur assisté par plasma) et PAPVD (dépôt physique en phase vapeur assisté par plasma), ou de gravure dans des procédés jouant sur l'équilibre gravure-dépôt (gravure sélective de $SiO_2$ par rapport au silicium, gravure anisotrope par passivation latérale)

L'invention peut également s'appliquer à des réacteurs de dépôt par CVD (silicium, tungstène), par laser, par MBE (épitaxie par jets moléculaires) dont il faut nettoyer périodiquement les parois pour éviter la re-déposition ou poussières sur les surfaces.

Art antérieur

Le problème du nettoyage des réacteurs en général, et des réacteurs de dépôt en particulier, revêt une importance cruciale en électronique, optique, micro-nanotechnologie, mais aussi, dans les traitements de surface (pulvérisation des métaux, dépôt de couches dures, tribologiques, anticorrosion) dans de très nombreux secteurs industriels. Le temps de nettoyage et donc d'immobilisation des réacteurs de production représente un coût important. Malgré ce coût, le nettoyage des réacteurs est une nécessité pour conserver qualité et reproductibilité aux procédés mis en oeuvre.

C'est pour cela qu'en microélectronique, la tendance est au nettoyage périodique (tous les "n" dépôts, voire après chaque dépôt), le plus souvent par nettoyage chimique par voie liquide ou par voie sèche (e.g. en plasma). C'est le cas par exemple du nettoyage des réacteurs de dépôt de Si, de $SiO_2$, ou de $Si_3N_4$ dans des réacteurs de type RF capacitif (décharge radiofréquence entre deux électrodes parallèles). Dans ce cas, les équipementiers ont différentes stratégies comme :

i) le nettoyage des réacteurs en bain liquide (voie chimique humide), mais le temps de démontage et de traitement du réacteur est prohibitif et requiert deux jeux des pièces à traiter ;

ii) la gravure plasma en utilisant des procédés doux, c'est-à-dire par voie chimique sèche purement réactive.

Pour cette raison, la plupart des équipementiers ont développé des procédés de nettoyage des réacteurs utilisant des plasmas auxiliaires de gaz aussi réactif que possible vis-à-vis des dépôts à éliminer par voie chimique réactive, et à pression relativement élevée pour produire les plus grandes concentrations possibles d'espèces réactives (par exemples, fluor atomique F pour la gravure chimique de Si, $SiO_2$, $Si_3N_4$, ou W, oxygène atomique O pour la gravure du carbone ou des polymères) et en chauffant les parois pour activer thermiquement les réactions chimiques de gravure.

Ainsi, il est possible de nettoyer du $SiO_2$ ou $Si_3N_4$ sur des parois de réacteurs recouvertes de ces dépôts en les portant à 300 à 400°C en présence d'un plasma de $NF_3$ généré par couplage RF inductif ou par onde de surface (POS). Toutefois, de manière générale, ce type de nettoyage n'est possible que si on peut former des produits de réaction volatils stables à partir des différents éléments du dépôt à éliminer.

Les techniques sèches de nettoyage proposées ci-dessus présentent le plus souvent, soit des temps de nettoyage par voie purement chimique souvent élevés, soit une forte agressivité chimique sur certains composants du réacteur à température élevée (fluor avec le nickel, oxygène avec les isolants diélectriques), d'où des coûts de nettoyage importants.

Elles requièrent, le plus souvent, la mise en oeuvre d'une source de plasma auxiliaire opérant à pression plus élevée que le plasma utilisé pour le procédé, et le choix de gaz exotiques ou difficiles à mettre en oeuvre, ce qui pose aussi le problème du coût du gaz (débits élevés), du retraitement de volumes de gaz importants en sortie de réacteur, et de la sécurité par la manipulation de gaz dangereux (toxiques, corrosifs, inflammables ou explosifs). Un exemple en est donné dans le document US 2005/0224458.

Le document JP03 150379 A divulgue un procédé de nettoyage par plasma d'un réacteur comportant l'application d'une polarisation positive au porte-substrats.

Les coûts d'investissement et de fonctionnement induits par les techniques actuelles sont donc extrêmement élevés.

Un objectif de l'invention est donc de proposer un dispositif de nettoyage ne nécessitant que des modifications mineures du réacteur.

Un objectif de l'invention est de proposer un procédé de nettoyage simplifié et s'appuyant sur des procédés de gravure chimique par voie sèche assistée par plasma, en particulier à l'aide du bombardement ionique.

C'est ce bombardement ionique qu'on se propose de contrôler dans l'invention.

Résumé de l'invention

Pour atteindre ces objectifs, il est prévu dans le cadre de la présente invention un procédé de nettoyage par voie chimique sèche assisté par plasma d'un réacteur comportant un dépôt indésirable sur ses parois et sur au moins une autre surface polarisable, caractérisé en ce qu'on effectue au moins une séquence, dite séquence positive, de nettoyage des parois du réacteur par polarisation positive de la ou de chaque surface polarisable, par rapport aux parois du réacteur, les parois étant à potentiel référencé.

Le procédé selon l'invention pourra en outre présenter au moins l'une des caractéristiques suivantes :

- on effectue au moins une autre séquence, dite séquence négative, de nettoyage de la ou de chaque surface polarisable par polarisation négative de celle-ci, par rapport aux parois du réacteur ;
- on effectue une séquence négative suivie d'une séquence positive ;
- on effectue au moins une succession alternative d'une séquence positive et d'une séquence négative ;
- on effectue une pluralité de successions alternatives périodiques d'une séquence positive et d'une séquence négative ;
- on effectue une polarisation à tension référencée de la ou chaque surface polarisable pendant la séquence positive ;
- on effectue une polarisation à tension référencée de la ou chaque surface polarisable pendant la séquence négative ;
- on effectue une autopolarisation de la ou chaque surface polarisable pendant la séquence négative.

Pour atteindre ces objectifs, il est également prévu dans le cadre de la présente invention un dispositif de nettoyage par voie chimique sèche assisté par plasma d'un réacteur comportant un dépôt indésirable sur ses parois et sur au moins une autre surface polarisable, caractérisé en ce qu'il comprend des moyens pour polariser positivement, par rapport aux parois du réacteur maintenues à un potentiel référencé, la ou chaque surface polarisable.

Le dispositif selon l'invention pourra en outre présenter au moins l'une des caractéristiques suivantes :

- il comprend des moyens pour polariser négativement, par rapport aux parois du réacteur, la ou chaque surface polarisable ;
- il comprend des moyens pour alterner successivement le signe de la polarisation, par rapport aux parois du réacteur, de la ou de chaque surface polarisable ;
- il comprend un générateur de tension continue, connecté électriquement à la ou à chaque surface polarisable, et des moyens de commande du générateur pour délivrer successivement des tensions positives et négatives, en référence aux parois du réacteur ;
- il comprend des moyens pour alterner successivement et périodiquement le signe de la polarisation, par rapport aux parois du réacteur, de la ou de chaque surface polarisable ;
- il comprend un générateur de tension périodique, connecté électriquement à la ou à chaque surface polarisable par l'intermédiaire d'un circuit comportant une capacité de faible impédance et des moyens pour court-circuiter la capacité ;
- il comprend un générateur de tension périodique, en connexion électrique directe avec la ou avec chaque surface polarisable et référencé par rapport aux parois du réacteur, qui sont préférentiellement à la masse.

Brève description des dessins

D'autres caractéristiques, buts, avantages et objectifs de la présente invention apparaîtront à la lecture de la description détaillée qui va suivre, et en regard des dessins annexés, donnés à titre d'exemples non limitatifs et sur lesquels :

- Fig. 1 représente à titre d'exemple des tensions continues appliquées à au moins une surface polarisable d'un réacteur, selon deux types de séquences, par rapport au potentiel référencé de paroi $V_w$ ;
- Fig. 2 représente, à titre d'exemple, un signal de tension $V(t)$ périodique fourni à au moins une surface polarisable, lors d'une séquence dite séquence 1 ou négative, dans laquelle la surface polarisable s'autopolarise négativement par rapport au potentiel référencé des parois $V_w$ ;
- Fig. 3a et 3b représentent, à titre d'exemples, des signaux de tensions périodiques fournis et appliqués à au moins une surface polarisable, lors d'une séquence dite séquence 2 ou positive, dans laquelle la surface polarisable présente périodiquement un potentiel positif par rapport au potentiel référencé des parois V$_w$ ;

- Fig. 4 représente, à titre d'exemple, un signal de tension périodique fourni et appliqué à au moins une surface polarisable, dans lequel la surface polarisable présente périodiquement un potentiel positif et négatif par rapport au potentiel référencé des parois V$_w$ ;
- Figs. 5, 6, 7 et 8 représentent schématiquement différentes variantes de réalisation d'un dispositif selon l'invention.

Description détaillée de l'invention

Le procédé selon l'invention est un procédé de nettoyage par gravure chimique assistée par plasma.

Celui-ci peut utiliser des procédés de gravure plasma conventionnels de la microélectronique et des microtechnologies, comme par exemples :

i) gravure du carbone C ou de composés carbonés (DLC, polymères,...) par plasmas contenant de l'oxygène,
ii) gravure du silicium Si ou du tungstène W par plasmas à base de fluor (SF$_6$, CF$_4$, NF$_3$,...)
iii) gravure de SiO$_2$ ou Si$_3$N$_4$ par plasmas à base de fluor (SF$_6$, CF$_4$, NF$_3$,...),
iv) gravure de Al, B, ou autres composés par plasmas à base de brome ou chlore (Br$_2$, Cl$_2$, HBr,...).

Pour que le procédé de nettoyage selon l'invention puisse être mis en oeuvre, il est nécessaire que le plasma soit produit dans un réacteur avec des parois à potentiels référencés (par exemple à la masse).

L'opération de nettoyage comporte au moins une séquence de nettoyage (par gravure plasma), dans laquelle les parois du réacteur sont nettoyées par polarisation positive, par rapport aux parois du réacteur, de la ou de chaque surface polarisable (par exemple, porte-substrat ou électrode). Cette ou ces séquence(s) sont appelées séquence 2 ou encore séquence positive dans la suite de la description.

L'opération comporte, selon l'application, au moins une autre séquence de nettoyage de la ou de chaque surface polarisable (par exemple, porte-substrat et/ou électrode) par polarisation négative de la surface polarisable par rapport aux parois du réacteur. Cette ou ces séquence(s) sont appelées séquence 1 ou encore séquence négative dans la suite de la description.

Nettoyage d'un dépôt conducteur

Si le dépôt à nettoyer est conducteur (C, W, Si ...), et que la surface polarisable n'a pas besoin d'être nettoyée (en raison de sa disposition au sein du réacteur par exemple, ou parce qu'elle porte un substrat pendant les opérations de dépôt, ou parce qu'on considère le dépôt comme négligeable), une séquence 2 peut suffire: il y a alors nettoyage complet des parois du réacteur (enceinte) par application à la surface polarisable (porte-substrat ou électrode) d'une tension continue positive par rapport aux parois.

Si le dépôt à nettoyer est conducteur (C, W, Si ...), et que la surface polarisable doit également être nettoyée, deux séquences successives seulement peuvent suffire, à savoir une séquence 1 et une séquence 2 : Il y a alors nettoyage complet de la surface polarisable par application à cette surface (porte-substrat ou électrode) d'une tension continue négative par rapport aux parois (par exemple à la masse), puis nettoyage complet des parois de l'enceinte par application à la surface (porte-substrat ou électrode) d'une tension continue positive par rapport aux parois.

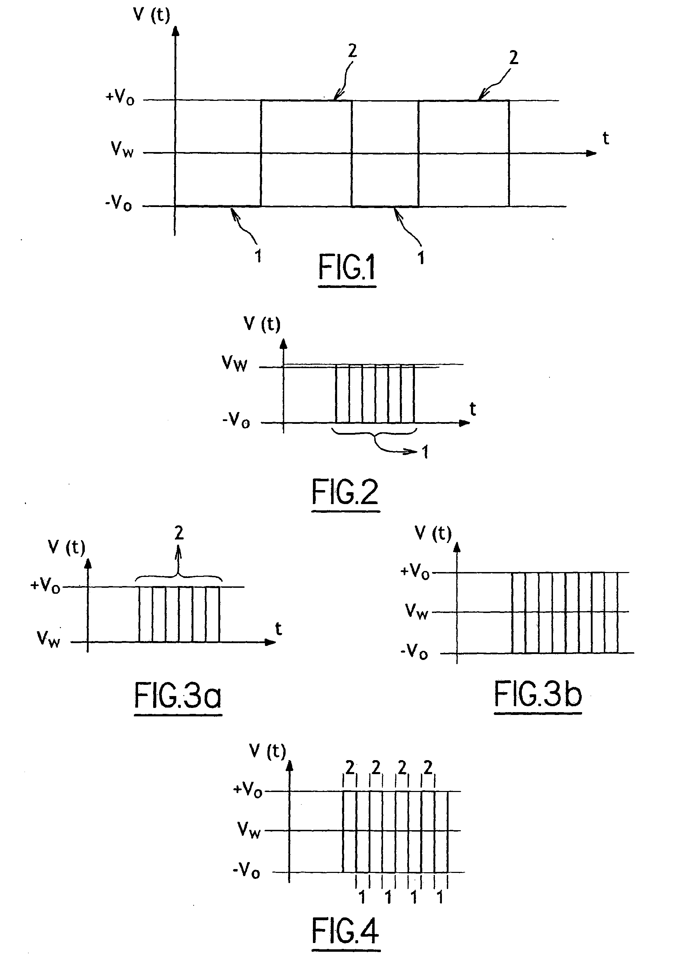

On pourra se référer à la Fig. 1 où la tension V(t) fournie à la surface polarisable et à laquelle elle est portée évolue d'une séquence 1, référencée 1, à une séquence 2, référencée 2, et où V$_w$ est le potentiel des parois du réacteur.

Notons que, dans le cadre de l'invention, il importe peu d'effectuer la séquence 1 suivie de la séquence 2 ou vice-versa. Toutefois, pratiquement, il est plus adapté de commencer par la séquence 1, c'est-à-dire d'effectuer le nettoyage de la surface polarisable.

La surface polarisable (porte-substrat ou électrode) peut être petite devant la surface des parois à nettoyer, mais elle doit présenter une dimension suffisamment grande pour perturber le plasma, de manière à ce que le potentiel du plasma V$_p$ se positionne, à chaque instant t, à une valeur toujours plus positive que la surface (paroi ou électrode) la plus positive.

La condition à remplir pour constituer un porte-substrat ou une électrode de grande dimension est que le rapport de la surface S$_s$ du porte substrat ou de l'électrode de grande dimension à la surface S$_w$ des parois soit au moins supérieure à environ 1,5 fois la racine carrée du rapport de la masse m$_e$ des électrons à celle des ions m$_i$, soit :

$$S_s \,/\, S_w > 1{,}5 \,(m_e \,/\, m_i)^{1/2} \qquad\qquad (1)$$

Pour l'argon, il faut donc que le rapport soit supérieur à 1/180 (1/30 pour l'hydrogène et 1/500 pour le xénon), ce qui est généralement le cas pour les porte-substrat ou électrodes utilisés en microélectronique ou dans les traitements de surface par fournée.

Au-dessous de la valeur du rapport donnée par l'Equation (1), la surface $S_s$ ne perturbe pas le plasma, ce qui correspond au cas des sondes électrostatiques ou sondes de Langmuir. Dans cette hypothèse, le potentiel plasma $V_p$ reste pratiquement inchangé par rapport au potentiel des parois (généralement à la masse) si on polarise positivement la surface polarisable de surface $S_s$ par rapport au potentiel $V_w$ des parois. L'énergie de bombardement ionique $W_w$ des parois du réacteur est alors proche de :

$$W_w \approx e(V_p - V_f) = (kT_e/\ 2)\ [1 + \ln\ (m_i\ /\ 2\pi\ m_e)] \qquad (2)$$

où k est la constante de Boltzmann, e la charge de l'électron, $T_e$ est la température électronique et $V_f$ le potentiel de la surface polarisable qui est flottant, alors égal en première approximation au potentiel des parois ($V_f \approx V_w$).

Au contraire, dans le cas général qui nous intéresse ici, celui d'un rapport $S_s\ /\ S_w$ supérieur à la valeur donnée par l'Equation (1), la surface polarisable $S_s$ perturbe profondément l'équilibre du plasma si elle est portée à un potentiel $V_o$ positif par rapport au potentiel des parois $V_w$ (séquence 2). Dans ce cas, le potentiel plasma $V_p$ est décalé de la valeur $V_o - V_w$ et l'énergie de bombardement ionique $W_w$ des parois vaut en première approximation, pour une tension $V_0$ continue :

$$W_w \approx e\ (V_p - V_w) = e\ (V_p - V_f + V_0 - V_w) \qquad (3)$$

Autrement dit, en polarisant positivement la surface polarisable $S_s$ au potentiel continu $V_o$ par rapport au potentiel des parois $V_w$ (séquence 2), il est possible de régler à la valeur voulue l'énergie de bombardement ionique sur les parois pendant la séquence 2. Durant cette même séquence, l'énergie de bombardement ionique $W_s$ de l'électrode vaut :

$$W_s \approx e(V_p - V_f) \qquad (4)$$

Si maintenant on polarise négativement la surface $S_s$ au potentiel continu - $V_o$ par rapport au potentiel des parois $V_w$ (séquence 1), l'énergie de bombardement ionique $W_s$ de la surface $S_s$ vaut :

$$W_s = e\ (V_p - V_s) = e\ (V_p - V_f + V_w - V_0) \qquad (5)$$

tandis que l'énergie de bombardement ionique $W_w$ des parois durant cette même séquence vaut :

$$W_w = e(V_p - V_f) \qquad (6)$$

On voit donc que les énergies de bombardement des parois et de l'électrode de grande dimension sont inversées lorsqu'on passe de la séquence 1 à la séquence 2.

Dans le cas du nettoyage d'un dépôt conducteur, sur les parois du réacteur et sur au moins une autre surface polarisable du réacteur, il est donc possible de nettoyer le réacteur en deux temps :

- nettoyage de la surface polarisable (porte-substrat ou électrode) de grande dimension pendant la séquence 1 en ajustant l'énergie du bombardement ionique $W_s$ par l'intermédiaire de la valeur - $V_o$ de la tension continue appliquée à la surface polarisable de grande dimension (Fig. 1), et

- nettoyage des parois du réacteur pendant la séquence 2 en ajustant l'énergie du bombardement ionique $W_w$ par l'intermédiaire de la valeur + $V_o$ de la tension continue appliquée à l'électrode de grande dimension (Fig. 1).

En effet, la vitesse de gravure chimique induite par le bombardement ionique augmentant rapidement avec l'énergie, un procédé de nettoyage rapide du réacteur requiert un bombardement ionique plus énergique que celui dû à la seule différence entre potentiel plasma et potentiel flottant de la surface polarisable.

Dans les équations (3) et (5) et sur la Fig. 1, $+ V_o$ et $- V_o$ sont des valeurs opposées, mais rien n'oblige à prendre des valeurs de polarisation $V_0$ symétriques. Toutefois, comme il est préférable de rester au-dessous ou proche des valeurs des seuils de pulvérisation du réacteur, il est plus commode de choisir des valeurs symétriques comme dans l'exemple précédent, avec typiquement $V_o$ = 30 à 100 V.

Comme évoqué ci-dessus, une séquence 2 ou une succession d'une séquence 1 et d'une séquence 2 peuvent suffire selon les cas. Toutefois, si le nettoyage des parois contamine la surface polarisable de grande dimension, ou réciproquement, il est préférable de prévoir un certain nombre de séquences alternées jusqu'au nettoyage complet du réacteur (parois et surface polarisable de grande dimension).

A noter que dans le cas où le porte-substrat est utilisé comme électrode de grande dimension, certaines parties cachées par le substrat peuvent s'avérer exemptes de dépôt. En fait le dépôt peut affecter uniquement les bords du porte-substrat, mais dans ce cas, il est préférable de nettoyer l'ensemble du porte-substrat (séquence 1).

Nettoyage d'un dépôt isolant électriquement

Si le dépôt à nettoyer est isolant ($SiO_2$, $Si_3N_4$ ...), et que la surface polarisable n'a pas besoin d'être nettoyée (pas de dépôt isolant), une séquence 2 peut suffire.

Dans le cas général, il est cependant indispensable d'appliquer une succession de séquences alternatives périodiques comportant les deux séquences décrites précédemment :

- nettoyage partiel de la surface polarisable (porte-substrat ou électrode) lors de l'alternance négative par rapport aux parois (généralement à la masse) d'une tension périodique appliquée à la surface polarisable, et
- nettoyage partiel des parois lors de l'alternance positive (par rapport aux parois) d'une tension périodique appliquée à la surface polarisable.

Ces séquences sont appliquées jusqu'au nettoyage complet du réacteur.

Là encore, on note que, dans le cadre de l'invention, il importe peu d'effectuer la séquence 1 suivie de la séquence 2 ou vice-versa. Toutefois, pratiquement, il est plus adapté de commencer par la séquence 1, c'est-à-dire d'effectuer le nettoyage de la surface polarisable.

Là également, le rapport des surfaces de la surface polarisable et des parois du réacteur doit répondre à l'équation (1).

La tension périodique de fréquence $f_0$, fournie par exemple par un générateur de tension périodique, est référencée par rapport au potentiel des parois du réacteur (généralement à la masse), ce qui n'est pas a priori le cas de la surface polarisable (on pense au mode par autopolarisation).

En effet, dans le cas du nettoyage d'un dépôt isolant, il n'est plus possible de nettoyer le réacteur avec des tensions de polarisation continues alternées (Fig. 1), et il est donc nécessaire de recourir à une polarisation périodique à plus haute fréquence par effet capacitif.

Ainsi, au cours d'une première séquence (séquence 1 ou séquence négative) de la polarisation périodique, il est usuel de réaliser l'autopolarisation négative de la surface polarisable (porte-substrat ou électrode de grande dimension) par application à la surface polarisable d'une tension périodique à travers une capacité de faible impédance (cas actuel de l'autopolarisation RF), et donc de nettoyer, par gravure chimique assistée par bombardement ionique (plasma), la surface polarisable de grande dimension.

Au cours de cette séquence 1, un moyen adapté fournit donc un signal de tension V(t) périodique (tel que celui illustré sur la Fig. 2) à la surface polarisable, qui, quant à elle, se polarise d'elle-même (autopolarisation) afin qu'elle reçoive, au cours d'une période, autant de charges positives (ions) que de charges négatives (électrons) compte tenu des valeurs de tension prises par ce signal et celle du potentiel plasma.

Cette autopolarisation résulte de la non-linéarité de la caractéristique courant/tension du plasma.

Une fois la surface polarisable (porte-substrat ou électrode) nettoyée, l'invention consiste à lui appliquer, au cours d'une seconde séquence (séquence 2 ou séquence positive), une tension périodique référencée (par exemple au potentiel des parois, généralement à la masse) de manière à ce que la tension appliquée à la surface polarisable pendant l'alternance positive prenne une valeur positive $+ V_o$ par rapport au potentiel des parois.

Des exemples de signal de tensions périodiques fournies par un moyen adapté à la surface polarisable sont illustrés sur les Fig. 3a et Fig. 3b. Sur la Fig. 3a, le signal fourni par le moyen adapté est celui porté sur la surface polarisable. En revanche, sur la Fig. 3b, le signal fourni par le moyen adapté est porté à la surface polarisable uniquement lorsque $V > V_w$ (séquence 2), la surface polarisable « voit » donc le même signal qu'à la Fig. 3a.

Autrement dit, il est ainsi possible de nettoyer la surface polarisable pendant la séquence 1 par gravure chimique assistée par plasma, et de nettoyer les parois du réacteur de la même manière durant la séquence 2.

Selon une variante à l'invention, on applique à la surface polarisable une tension périodique référencée (par exemple au potentiel des parois, généralement à la masse) de manière à ce que la tension appliquée à la surface polarisable pendant les alternances négatives (séquences 1) prenne une valeur négative - $V_o$ par rapport au potentiel des parois, et à ce que la tension appliquée pendant les alternances positives (séquences 2) prenne une valeur positives + $V_o$ par rapport au potentiel des parois (Fig. 4).

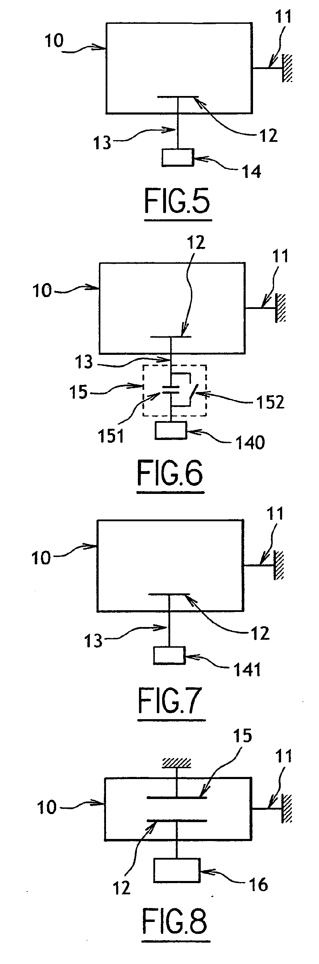

Dans cette variante, on comprend qu'il n'y a plus d'autopolarisation négative de la surface polarisable (sauf tant que subsiste un dépôt isolant). Pour ce faire, la capacité de faible impédance est court-circuitée (Fig. 6) afin que la tension fournie par des moyens adaptés corresponde à la tension portée à la surface polarisable.

Par rapport au cas du nettoyage par applications successives de tensions continues, les valeurs d'autopolarisation calculées dans le cas de l'application de tensions périodiques sont plus complexes que dans les équations (2) à (6) présentées ci-dessus et dépendent plus ou moins fortement de la pulsation angulaire $\omega_0 = 2\pi f_0$ (par rapport à la pulsation plasma ionique), de la forme du signal périodique, ou du rapport des surfaces $S_s$ et $S_w$.

On note cependant que la pulsation angulaire $\omega_0$ des séquences de nettoyage n'est pas une donnée limitative du procédé. En particulier, cette pulsation angulaire peut être inférieure ou supérieure à la pulsation plasma ionique $\omega_{pi}$ définie par $\omega_{pi}^2 = n\, e^2 / \varepsilon_0\, m_i$ où n est la densité du plasma, -e la charge de l'électron, $m_i$ la masse des ions du plasma et $\varepsilon_0$ la permittivité du vide.

Il est également à noter que la forme du signal périodique (la succession de séquences alternatives périodiques) peut être sinusoïdale, rectangulaire, ou autres.

Cependant, les valeurs calculées dans les équations (2) à (6) sont pratiquement valables dans le cas de l'application de signaux rectangulaires ou de tensions périodiques de pulsation angulaire $\omega_0 \ll \omega_{pi}$ et de surfaces $S_s$ et $S_w$ très dissymétriques.

Il faut également noter que le procédé de nettoyage par application de tensions périodiques tel que décrit ci-dessus n'a de sens que si le rapport des surfaces $S_s$ et $S_w$ est petit ($S_s / S_w \ll 1$). En effet, si les surfaces $S_s$ et $S_w$ sont de dimensions proches ($S_s \approx S_w$), une seule séquence d'autopolarisation suffit puisque la polarisation des deux surfaces est alors symétrique par rapport au signal appliqué, chaque surface étant tour à tour polarisée négativement par rapport au potentiel plasma.

Le nettoyage par succession de séquences alternatives périodiques présenté ci-dessus lorsque le dépôt à nettoyer est isolant peut s'appliquer aussi au nettoyage des dépôts conducteurs. Toutefois, le nettoyage des dépôts conducteurs en deux ou plusieurs séquences sous tension continue procure l'avantage de ne pas nécessiter de générateur de tension périodique, beaucoup plus coûteux qu'une alimentation continue.

Comme évoqué ci-dessus et dans la mesure du possible, les tensions appliquées (que le dépôt soit conducteur ou isolant) doivent être réglées de façon à ce que l'énergie de bombardement ionique de l'électrode ou des parois du réacteur reste au-dessous ou proche du seuil de pulvérisation des matériaux qui les constituent (pulvérisation négligeable de l'électrode et des parois du réacteur), c'est-à-dire typiquement au dessous de 100 eV.

Le procédé selon l'invention décrit ci-dessus est mis en oeuvre avec des moyens détaillés ci-dessous.

Plus précisément, les dispositifs de nettoyage selon l'invention comportent, et ce de manière connue dans les dispositifs de nettoyage par voie chimique sèche assisté par plasma, des moyens de production dans un réacteur d'un plasma réactif capable de former avec les dépôts à éliminer des produits de réaction volatils.

Ces moyens comportent également une surface polarisable (porte-substrat ou électrode) de surface $S_s$ suffisante par rapport à la surface $S_w$ des parois [équation (1)] pour permettre la modification du potentiel plasma. La surface polarisable est alors dite de grande dimension.

Ces moyens comportent encore des moyens d'appliquer à la surface polarisable de grande dimension des séquences successives de polarisation à partir de tensions continues ou périodiques selon le procédé de l'invention.

Différents dispositifs selon l'invention peuvent être décrits. En particulier, les moyens de production de plasma peuvent consister en différents types de plasmas comme les plasmas micro-onde, par exemple les plasmas à résonance cyclotronique électronique distribués (DECR), les plasmas multi-dipolaires (exemples non limitatifs), comme les décharges capacitives continues ou radiofréquence, diodes ou triodes, où l'une des électrodes est utilisée comme porte-substrat polarisable, ou comme les décharges inductives avec inducteur interne à l'enceinte. Dans tous ces exemples, les porte-substrat répondent généralement au critère de rapport des surfaces de l'équation (1).

Pour ce qui concerne l'application de séquences successives de tensions continues (uniquement pour les dépôts conducteurs), une alimentation pilotée, capable de délivrer successivement des tensions continues positives et négatives, est nécessaire.

Pour l'application d'une tension périodique d'autopolarisation négative (séquence 1, dépôt isolant), un moyen conventionnel consiste en un générateur capable de délivrer une tension périodique à travers une capacité de faible impédance.

En revanche, obtenir une tension de polarisation positive pendant l'alternance positive (séquence 2, dépôt isolant) requiert un générateur capable de délivrer une tension périodique référencée par rapport à un potentiel défini.

Autrement dit, l'invention requiert, dans de très nombreux cas, un générateur capable de délivrer successivement, soit une tension périodique à travers une capacité de faible impédance (polarisation du substrat pendant le procédé précédant le nettoyage et/ou pendant la séquence 1), soit une tension périodique référencée présentant pendant l'alternance positive (séquence 2) une tension positive par rapport au potentiel de la paroi.

Selon la variante de réalisation évoquée ci-dessus dans le cadre du procédé (séquence 1, dépôt isolant), un dispositif selon l'invention devra alors requérir un générateur capable de délivrer une tension périodique référencée par rapport à la paroi, c'est-à-dire présentant une tension périodiquement négative puis positive, symétrique par exemple par rapport au potentiel de la paroi.

Ainsi, un premier dispositif comporte des moyens d'appliquer des tensions continues négatives et positives, en référence aux parois du réacteur, à une surface polarisable (porte-substrat, par exemple), et ce de manière indépendante ou non de la production du plasma.

Ce premier dispositif est illustré sur la Fig. 5. Il présente un réacteur 10 référencé à la masse 11, une surface polarisable 12 connectée électriquement par un moyen 13 à un générateur de tension continue 14, comprenant des moyens de commande du générateur pour délivrer successivement des tensions positives et négatives, en référence aux parois du réacteur.

Un second dispositif (Fig. 6) comprend un générateur de tension périodique 140, connecté électriquement à la ou à chaque surface polarisable 12 par l'intermédiaire d'un circuit 15 comportant une capacité 151 de faible impédance et des moyens 152 pour court-circuiter la capacité. Avec ce dispositif, la polarisation de la surface polarisable se fait de manière indépendante ou non de la production du plasma.

Les moyens 152 pour court-circuiter peuvent par exemple, mais non limitativement, être formés par un commutateur, disposé en parallèle de la capacité de faible impédance. Dans ce cas, le commutateur est ouvert pendant une séquence 1 (Fig. 6 et Fig. 2), de sorte que la tension générée par le générateur passe par la capacité avant d'arriver sur la ou chaque surface polarisable. Au contraire, le commutateur est fermé pour une séquence 2, de sorte que la tension générée par le générateur est la tension de la ou de chaque surface polarisable (Fig. 3a et Fig. 3b).

Un troisième dispositif comporte des moyens d'appliquer une tension périodique, par exemple par un générateur de tension périodique 141, à la ou à chaque surface polarisable 12, au moyen d'une connexion électrique 13 directe (Fig. 7). Cette tension est référencée au potentiel des parois du réacteur (généralement à la masse), et ce de manière indépendante ou non de la production du plasma.

Il est à noter que dans le cas de décharges capacitives entre électrodes, la polarisation n'est pas indépendante de la production du plasma, alors qu'elle l'est généralement dans les plasmas inductifs et les plasmas micro-onde.

Un des principaux avantages de l'invention est sa simplicité en termes de procédé et de dispositif par rapport aux techniques actuelles.

En effet, la séquence 1 ou séquence négative évoquée dans la description ci-dessus utilise des procédés de gravure assistés par plasma connus dans la mesure où la ou chaque surface polarisable est polarisée négativement par rapport au potentiel plasma (qui est légèrement supérieur au potentiel des parois).

La séquence 2 ou séquence positive, quant à elle, vient donc modifier le fonctionnement nominal du réacteur pour atteindre un objectif de nettoyage des parois du réacteur qui sont pour cela mise à un potentiel référencé.

Pour certains types d'applications connues de l'homme du métier, on utilise, en plus d'une cathode (qui constitue une surface polarisable) polarisée négativement par rapport au potentiel plasma, au moins une anode destinée à recueillir les électrons, qui est, en fonctionnement nominal, polarisée positivement par rapport au potentiel plasma.

Toutefois, dans ce type d'applications et pour éviter des dépôts isolants sur cette ou sur ces anode(s), on prévoit des moyens pour polariser négativement la ou les anode(s) par rapport au potentiel plasma (les parois ne sont pas référencées dans ce type d'applications). Ce procédé, qui peut être apparenté à une séquence 1 telle que décrit ci-dessus du point de vue de la ou des anode(s), est effectué dans l'objectif d'assurer la continuité de fonctionnement nominal du réacteur, en s'assurant que l'anode joue son rôle de collecteur d'électrons. C'est le cas par exemple du document EP 1 458 006.

Parmi les avantages que l'invention procure, on peut en particulier citer qu'elle:

1) met en oeuvre des procédés conventionnels de gravure, éprouvés et maîtrisés ;
2) ne nécessite pas de modification de l'architecture du réacteur ;
3) ne requiert que des modifications mineures des alimentations de polarisation de la surface polarisable (porte-substrat ou électrode);
4) n'entraîne pas de pulvérisation de la surface polarisable si la polarisation de celle-ci est indépendante de la production du plasma (exemple des plasmas produits par micro-ondes), et est maintenue à une valeur inférieure à celle correspondant à la pulvérisation des surfaces du réacteur.
5) offre un procédé peu dommageable pour le réacteur et pour l'environnement.

Pour se fixer les idées, la Demanderesse fournit ci-dessous un exemple d'application typique de son invention, donné à titre d'exemple non limitatif.

On considère une décharge capacitive dans un réacteur 10 à la masse 11 créée entre une surface polarisable 12 (porte-substrat) sur lequel est appliqué une tension et une électrode 15 à la masse (Fig. 8) ou aussi un réacteur de mêmes dimensions dans lequel le plasma est produit par micro-ondes et où le même porte-substrat peut être polarisé par une tension. L'élément 16, correspond, selon le type de tension généré, au générateur 14 de la Fig. 5 à l'ensemble formé par le générateur 140 et le circuit 15 de la Fig. 6, ou encore au générateur 141 de la Fig. 7.

Les rapports des surfaces à la masse et celles polarisables en continu ou périodique (RF) est de 700 cm$^2$ / 7000 cm$^2$, soit 1 / 10, ce qui correspond parfaitement au critère défini par l'équation (1) et au cas d'une surface de porte-substrat petite devant la surface des parois.

Un exemple bien connu est l'élimination des dépôts de $SiO_2$ sur les parois d'un réacteur de dépôt. Dans le cadre de l'invention, ce dépôt peut être éliminé à l'aide d'un plasma de $SF_6$ par la formation des produits de réaction $SiF_4$ et $O_2$ par gravure chimique assistée par bombardement ionique. A noter que l'utilisation de $CF_4$, et plus généralement de gaz carbono-fluorés peut conduire, suivant les paramètres plasma, à un dépôt $CF_x$ de type téflon.

## Revendications

1. Procédé de nettoyage par voie chimique sèche assisté par plasma d'un réacteur (10) comportant un dépôt indésirable sur ses parois et sur au moins une autre surface (12) polarisable, **caractérisé en ce qu'**on effectue une pluralité de successions alternatives :

   • d'une séquence dite négative (1) de nettoyage de la ou de chaque surface polarisable par polarisation négative de celle-ci, par rapport aux parois du réacteur ; et
   • d'une séquence dite positive (2) de nettoyage des parois du réacteur par polarisation positive de la ou de chaque surface polarisable, par rapport aux parois du réacteur, les parois étant à potentiel référencé.

2. Procédé selon la revendication précédente, **caractérisé en ce qu'**on effectue une pluralité de successions alternatives périodiques d'une séquence négative (1) et d'une séquence positive.

3. Procédé selon l'une des revendications précédentes, **caractérisé en ce qu'**on effectue une polarisation à tension référencée de la ou chaque surface (12) polarisable pendant la séquence positive (2).

4. Procédé selon l'une des revendications précédentes, **caractérisé en ce qu'**on effectue une polarisation à tension référencée de la ou chaque surface (12) polarisable pendant la séquence négative (1).

5. Procédé selon l'une des revendications précédentes, **caractérisé en ce qu'**on effectue une autopolarisation de la ou chaque surface polarisable (12) pendant la séquence négative (1).

6. Dispositif de nettoyage par voie chimique sèche assisté par plasma d'un réacteur (10) comportant un dépôt indésirable sur ses parois et sur au moins une autre surface (12) polarisable, **caractérisé en ce qu'**il comprend :

   • des moyens (13, 14, 140, 15, 16) pour polariser négativement, par rapport aux parois du réacteur, la ou chaque surface polarisable ;
   • des moyens (13, 14, 140, 15, 16) pour polariser positivement, par rapport aux parois du réacteur maintenues à un potentiel référencé, la ou chaque surface polarisable ;
   • des moyens (14, 15, 140, 16) pour alterner successivement le signe de la polarisation, par rapport aux parois du réacteur, de la ou de chaque surface polarisable.

7. Dispositif selon la revendication précédente, **caractérisé en ce qu'**il comprend un générateur de tension continue (14), connecté électriquement à la ou à chaque surface polarisable, et des moyens de commande du générateur pour délivrer successivement des tensions positives et négatives, en référence aux parois du réacteur.

8. Dispositif selon l'une des revendications 6 ou 7, **caractérisé en ce qu'**il comprend des moyens pour alterner successivement et périodiquement le signe de la polarisation, par rapport aux parois du réacteur, de la ou chaque surface polarisable.

9. Dispositif selon la revendication précédente, **caractérisé en ce qu'**il comprend un générateur de tension périodique (140), connecté électriquement à la ou à chaque surface polarisable par l'intermédiaire d'un circuit (15) comportant une capacité (151) de faible impédance et des moyens (152) pour court-circuiter la capacité.

**10.** Dispositif selon la revendication 7, **caractérisé en ce qu'**il comprend un générateur de tension périodique (140), en connexion électrique (13) directe avec la ou avec chaque surface polarisable et référencé par rapport aux parois du réacteur, qui sont préférentiellement à la masse.

**11.** Dispositif selon l'une des revendications 7 à 10, **caractérisé en ce que** la surface polarisable présente une dimension telle qu'elle vérifie l'inégalité :

$$S_s / S_w > 1,5 \, (m_e / m_i)^{1/2}$$

pour perturber le plasma, de sorte que le potentiel du plasma $V_p$ se positionne, à chaque instant t, à une valeur plus positive que la surface la plus positive du réacteur, et où $S_s$ est la surface polarisable, $S_w$ la surface des parois du réacteur, $m_e$ la masse des électrons du plasma et $m_i$ celle des ions du plasma.

**Claims**

**1.** Method for cleaning, by means of a plasma-assisted dry chemical process, a reactor (10) having an undesirable deposit on the walls thereof and on at least one other biasable surface (12), **characterised in that** a plurality of alternating successions are performed:

- of a so-called negative sequence (1) for cleaning the or each biasable surface by negative biasing thereof, with respect to the walls of the reactor; and
- a so-called positive sequence (2) for cleaning the walls of the reactor by positive biasing of the or each biasable surface, with respect to the walls of the reactor, the walls being at a referenced potential.

**2.** Method according to the above claim, **characterised in that** a plurality of periodic alternating successions of a negative sequence (1) and a positive sequence are performed.

**3.** Method according to any of the above claims, **characterised in that** biasing at a referenced voltage of the or each biasable surface (12) is performed during the positive sequence (2).

**4.** Method according to any of the above claims, **characterised in that** biasing at a referenced voltage of the or each biasable surface (12) is performed during the negative sequence (1).

**5.** Method according to any of the above claims, **characterised in that** auto-biasing of the or each biasable surface (12) is performed during the negative sequence (1).

**6.** Device for cleaning, by means of a plasma-assisted dry chemical process, a reactor (10) having an undesirable deposit on the walls thereof and on at least one other biasable surface (12), **characterised in that** it comprises:

- means (13, 14, 140, 15, 16) for negatively biasing, with respect to the walls of the reactor, the or each biasable surface;
- means (13, 14, 140, 15, 16) for positively biasing, with respect to the walls of the reactor maintained at a reference potential, the or each biasable surface;
- means (14, 15, 140, 16) for successively alternating the sign of the biasing, with respect to the walls of the reactor, of the or each biasable surface.

**7.** Device according to the above claim, **characterised in that** it comprises a DC voltage generator (14) electrically connected to the or each biasable surface, and means for controlling the generator in order to successively deliver positive and negative voltages, with reference to the walls of the reactor.

**8.** Device according to any of claims 6 or 7, **characterised in that** it comprises means for successively and periodically alternating the sign of the biasing, with respect to the walls of the reactor, of the or each biasable surface.

**9.** Device according to the above claim, **characterised in that** it comprises a periodic voltage generator (140), electrically connected to the or each biasable surface by means of a circuit (15) comprising a low-impedance capacitor (151) and means (152) for short-circuiting the capacitor.

10. Device according to claim 7, **characterised in that** it comprises a periodic voltage generator (140) in direct electrical connection (13) with the or each biasable surface and referenced with respect to the walls of the reactor, which are preferably earthed.

11. Device according to any of claims 7 to 10, **characterised in that** the biasable surface has a dimension such that it satisfies the inequality:

$$S_s\ /\ S_w\ >\ 1.5(m_e\ /\ m_i)^{1/2}$$

so as to disturb the plasma, such that the potential of the plasma $V_p$ is positioned, at each time t, at a value more positive than the most positive surface of the reactor, and where $S_s$ is the biasable surface area, $S_w$ the surface area of the walls of the reactor, $m_e$ the mass of the electrons of the plasma and $m_i$ that of the ions of the plasma.

**Patentansprüche**

1. Verfahren zur plasmaunterstützten trockenchemischen Reinigung eines Reaktors (10), welcher eine unerwünschte Ablagerung auf seinen Wandungen und auf wenigstens einer anderen polarisierbaren Oberfläche (12) aufweist, **dadurch gekennzeichnet, dass** man eine Mehrzahl an wechselnden Aufeinanderfolgen

   • einer als negativ bezeichneten Reinigungssequenz (1) der oder jeder polarisierbaren Oberfläche durch deren negative Polarisation in Bezug auf die Wandungen des Reaktors; und
   • einer als positiv bezeichneten Reinigungssequenz (2) der Wandungen des Reaktors durch positive Polarisation der oder jeder polarisierbaren Oberfläche in Bezug auf die Wandungen des Reaktors, wobei die Wandungen im Bezugspotential vorliegen,

   durchführt.

2. Verfahren gemäß dem vorhergehenden Anspruch, **dadurch gekennzeichnet, dass** man eine Mehrzahl an periodischen wechselnden Aufeinanderfolgen einer negativen Sequenz (1) und einer positiven Sequenz (2) durchführt.

3. Verfahren gemäß einem der vorhergehenden Ansprüche, **dadurch gekennzeichnet, dass** man eine Polarisation bei Bezugsspannung der oder jeder polarisierbaren Oberfläche (12) während der positiven Sequenz (2) durchführt.

4. Verfahren gemäß einem der vorhergehenden Ansprüche, **dadurch gekennzeichnet, dass** man eine Polarisation bei Bezugsspannung der oder jeder polarisierbaren Oberfläche (12) während der negativen Sequenz (1) durchführt.

5. Verfahren gemäß einem der vorhergehenden Ansprüche, **dadurch gekennzeichnet, dass** man eine Selbstpolarisation der oder jeder polarisierbaren Oberfläche (12) während der negativen Sequenz (1) durchführt.

6. Vorrichtung zur plasmaunterstützten trockenchemischen Reinigung eines Reaktors (10), welcher eine unerwünschte Ablagerung auf seinen Wandungen und auf wenigstens einer anderen polarisierbaren Oberfläche (12) aufweist, **dadurch gekennzeichnet, dass** sie umfasst:

   • Mittel (13, 14, 140, 15, 16) zur negativen Polarisation, in Bezug auf die Wandungen des Reaktors, der oder jeder polarisierbaren Oberfläche;
   • Mittel (13, 14, 140, 15, 16) zur positiven Polarisation, in Bezug auf die Wandungen des Reaktors, die bei einem Bezugspotential gehalten werden, der oder jeder polarisierbaren Oberfläche;
   • Mittel (14, 15, 140, 16) für einen aufeinander folgenden Wechsel des Vorzeichens der Polarisation, in Bezug auf die Wandungen des Reaktors, der oder jeder polarisierbaren Oberfläche.

7. Vorrichtung gemäß dem vorhergehenden Anspruch, **dadurch gekennzeichnet, dass** sie einen Gleichspannungsgenerator (14), der elektrisch mit der oder jeder polarisierbaren Oberfläche verbunden ist, und Mittel zur Steuerung des Generators, so dass aufeinander folgend positive und negative Spannungen, in Bezug auf die Wandungen des Reaktors, abgegeben werden, umfasst.

8. Vorrichtung gemäß einem der Ansprüche 6 oder 7, **dadurch gekennzeichnet, dass** sie Mittel für einen aufeinander folgenden und periodischen Wechsel des Vorzeichens der Polarisation, in Bezug auf die Wandungen des Reaktors, der oder jeder polarisierbaren Oberfläche umfasst.

9. Vorrichtung gemäß dem vorhergehenden Anspruch, **dadurch gekennzeichnet, dass** sie einen Generator (140) zur Erzeugung periodischer Spannung umfasst, der durch einen Stromkreis (15), der eine Kapazität (151) mit geringer Impedanz und Mittel (152) zum Kurzschließen der Kapazität aufweist, elektrisch mit der oder jeder polarisierbaren Oberfläche verbunden ist.

10. Vorrichtung gemäß Anspruch 7, **dadurch gekennzeichnet, dass** sie einen Generator (140) zur Erzeugung periodischer Spannung in direkter elektrischer Verbindung (13) mit der oder jeder polarisierbaren Oberfläche und ausgedrückt in Bezug auf die Wandungen des Reaktors, die bevorzugt geerdet sind, umfasst.

11. Vorrichtung gemäß einem der Ansprüche 7 bis 10, **dadurch gekennzeichnet, dass** die polarisierbare Oberfläche eine Dimension aufweist, die folgende Ungleichung erfüllt:

$$S_S / S_W > 1{,}5 \, (m_e / m_i)^{1/2}$$

um das Plasma derart zu stören, dass sich das Plasmapotential $V_p$ zu jedem Zeitpunkt t auf einen positiveren Wert als die positivste Oberfläche des Reaktors einstellt, wobei $S_s$ die polarisierbare Oberfläche, $S_w$ die Oberfläche der Wandungen des Reaktors, $m_e$ die Elektronenmasse des Plasmas und $m_i$ die Ionenmasse des Plasmas sind.

FIG.1

FIG.2

FIG.3a

FIG.3b

FIG.4

FIG.5

FIG.6

FIG.7

FIG.8

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- US 20050224458 A
- JP 3150379 A
- EP 1458006 A